# FASCICULE DE BREVET EUROPEEN

(11) **EP 2 876 689 B1**
(45) Date de publication et mention de la délivrance du brevet: **01.06.2016**
(21) Numéro de dépôt: 14194474.4
(22) Date de dépôt: 24.11.2014
(51) Int. Cl.: H01L 31/0224, H01L 31/0236

(54) **Procédé de formation d'une cellule photovoltaïque**
Verfahren zur Herstellung einer Fotovoltaikzelle
Method for forming a photovoltaic cell

(30) Priorité: 25.11.2013 FR 1361575
(43) Date de publication de la demande: 27.05.2015
(73) Titulaire: Commissariat à l'Énergie Atomique et aux Énergies Alternatives, 75015 Paris (FR)
(72) Inventeur: Cabal, Raphaël, 73000 CHAMBERY (FR)
(74) Mandataire: Brevalex

(56) Documents cités:
- EP-A1- 1 367 652
- EP-A1- 2 264 786
- WO-A1-2010/019887
- KR-A- 20120 133 411
- US-A- 5 356 488
- US-A1- 2010 200 065
- HEZEL R ET AL: "A new strategy for the fabrication of cost-effective silicon solar cells", 8 mai 1998 (1998-05-08), RENEWABLE ENERGY, PERGAMON PRESS, OXFORD, GB, PAGE(S) 83 - 88, XP004126823, ISSN: 0960-1481 * abrégé *; figures 1a, 1b *

## Description

### DOMAINE TECHNIQUE

La présente invention concerne un procédé de formation d'une cellule photovoltaïque, et plus particulièrement un procédé de formation de contacts conducteurs d'une cellule photovoltaïque.

### ÉTAT DE LA TECHNIQUE ANTÉRIEURE

Les contacts conducteurs ou métallisations d'une cellule photovoltaïque sont couramment réalisés par sérigraphie de pâtes métalliques.

La face d'une cellule photovoltaïque qui est destinée à être exposée au rayonnement lumineux, dite face avant, est couramment recouverte d'une couche antireflet. De telles couches antireflet, couramment désignées par l'acronyme d'origine anglo-saxonne ARC (« Anti Reflective Coating »), sont habituellement isolantes électriquement.

Pour former un contact conducteur sur une zone d'une cellule photovoltaïque recouverte d'une couche antireflet, une solution consiste à déposer une pâte conductrice par sérigraphie sur la couche antireflet puis à réaliser un traitement thermique. Le traitement thermique permet de réaliser la prise de contact en permettant à la pâte conductrice de traverser la couche antireflet et d'atteindre la zone de la cellule à contacter.

Les pâtes métalliques utilisées dépendent notamment du type de conductivité des zones de la cellule photovoltaïque que l'on souhaite contacter. Plusieurs pâtes métalliques différentes sont couramment utilisées pour former les contacts conducteurs d'une même cellule photovoltaïque. Il existe alors un compromis difficile à satisfaire pour trouver des conditions de traitement thermique optimales pour les différentes pâtes métalliques. Il en résulte une dégradation des performances électriques et/ou mécaniques des contacts, par exemple une faible adhérence des contacts.

En outre, un traitement thermique correspondant à un budget thermique trop élevé pour une pâte métallique peut entraîner une avancée du contact dans la zone dopée à contacter. Il en résulte une dégradation de la qualité électrique de la jonction photovoltaïque, ce qui entraîne une réduction des performances électriques de la cellule photovoltaïque, notamment une réduction de la tension de circuit ouvert (V_{OC}). Ce phénomène est notamment observé dans le cas de l'utilisation de pâtes métalliques à base d'argent et d'aluminium pour contacter des couches dopées au bore de cellules photovoltaïques comprenant un substrat de type N. Le contact peut même atteindre le substrat, ce qui a pour effet de court-circuiter la jonction de la cellule photovoltaïque. Il en résulte une dégradation des performances électriques de la cellule photovoltaique, notamment une réduction de son facteur de forme FF (« Fill Factor » en anglais).

### EXPOSÉ DE L'INVENTION

La présente invention propose un procédé de formation de contacts conducteurs d'une cellule photovoltaïque par sérigraphie visant notamment à résoudre ces problèmes.

Il a déjà été proposé d'augmenter la profondeur de la zone dopée à contacter par redistribution des éléments dopants. Une telle redistribution des éléments dopants peut être réalisée par voie thermique, de manière globale à l'échelle du substrat. Un exemple d'une telle méthode de redistribution des éléments dopants est décrit dans l'article de L.J. Koduvelikulathu et al. intitulé « Metallization and firing process impact on VOC - a simulation study » (Proceedings of the 27th EUPVSEC, p.1432-1434, 2012). Une autre méthode de redistribution des éléments dopants utilise la voie laser, et dans ce cas la redistribution des éléments dopants s'effectue de manière localisée. Un exemple d'une telle méthode est décrit dans l'article de S. Hopman et al. intitulé « Study on laser parameters for silicon solar cells with LCP selective emitters » (Proceedings of the 24th EUPVSEC, p.1072-1076 2009). EP1367 652 A1, décrit un procédé de formation de cellule photo voltaïque comporant au moins deux cavités et un pilier.

Un inconvénient de telles méthodes est lié au fait que la redistribution des éléments dopants entraîne une réduction de la concentration des éléments dopants en surface. Il en résulte une augmentation de la résistance électrique à l'interface entre le contact conducteur et la zone dopée à contacter.

En outre, un inconvénient des méthodes de redistribution des éléments dopants par voie thermique est lié au fait que la redistribution des éléments dopants en profondeur s'effectue sur l'ensemble de la surface du substrat, ce qui a pour effet d'augmenter l'activité recombinante au sein de la cellule photovoltaïque et donc de dégrader le courant de court-circuit (I_{CC}). Un autre inconvénient des méthodes de redistribution des éléments dopants par voie thermique est lié au fait que le budget thermique requis pour redistribuer significativement les éléments dopants, c'est-à-dire sur une profondeur supérieure à 1 µm, est élevé. Un traitement thermique est par exemple effectué à une température supérieure à 950°C pendant une durée supérieure à 1 heure. Il en résulte une dégradation de la qualité du substrat.

Un inconvénient des méthodes de redistribution des éléments dopants par voie laser est lié au fait que le faisceau laser est susceptible d'introduire localement des défauts dans le substrat.

La présente invention propose un procédé de formation de contacts conducteurs d'une cellule photovoltaïque permettant d'éloigner les contacts conducteurs de la jonction photovoltaïque. Plus précisément, la présente invention propose d'éloigner de la jonction photovoltaïque l'interface entre le contact conducteur et la zone dopée à contacter. Pour cela, une structuration particulière est formée à la surface du substrat et une couche tampon est localisée au fond des motifs de structuration.

La présente invention concerne un procédé de formation d'une cellule photovoltaïque, comprenant les étapes suivantes :
a) former un motif de structuration, comportant au moins deux cavités et au moins un pilier, à partir de la surface d'un substrat semi-conducteur ;
b) former à partir de la surface du substrat une zone dopée selon le type de conductivité opposé à celui du substrat, de façon que le pilier soit formé de ladite zone dopée ;
c) former une couche tampon au fond d'au moins une cavité ; et
d) former un contact conducteur avec la zone dopée située dans le pilier, par dépôt sérigraphique dans ladite au moins une cavité sur la couche tampon et traitement thermique de reprise de contact.

Le pilier est entièrement formé de ladite zone dopée.

Selon un mode de réalisation de la présente invention, lors de l'étape b), la zone dopée est formée de façon conforme par rapport au motif de structuration.

Selon un mode de réalisation de la présente invention, le procédé comprend en outre, entre les étapes b) et c), une étape de formation d'une couche électriquement isolante sur la surface du substrat.

La couche électriquement isolante peut être une couche antireflet et/ou une couche de passivation.

Lors de l'étape de traitement thermique de reprise de contact, la couche antireflet est partiellement éliminée et l'avancée du contact conducteur dans la zone dopée s'effectue perpendiculairement à l'interface entre le contact conducteur et la zone dopée.

Un avantage d'un procédé du type de celui décrit ci-dessus réside dans le fait qu'il permet d'éviter tout risque de court-circuit et/ou de dégradation électrique de la jonction photovoltaïque entre le substrat et la zone dopée.

La largeur de l'au moins un pilier est inférieure ou égale à deux fois l'épaisseur de ladite zone dopée. Ainsi, l'au moins un pilier ne comprend pas de jonction P/N.

Selon un mode de réalisation de la présente invention, lors de l'étape a), on forme un motif de structuration comportant une cavité principale et une première et une seconde cavités secondaires disposées de part et d'autre de la cavité principale et séparées de celle-ci par un premier et un second piliers. Lors de l'étape c), on forme une couche tampon au fond de la cavité principale. Lors de l'étape d), on forme un contact conducteur dans la cavité principale.

La profondeur de la première cavité secondaire et la profondeur de la seconde cavité secondaire sont inférieures ou égales à la profondeur de la cavité principale.

Les première et seconde cavités secondaires peuvent être de même profondeur et de même largeur.

Selon un mode de réalisation de la présente invention, lors de l'étape a), on forme un motif de structuration comportant une première cavité et une seconde cavité séparées par un pilier. Lors de l'étape c), on forme une couche tampon au fond des première et seconde cavités. Lors de l'étape d), on forme un contact conducteur dans les première et seconde cavités autour du pilier.

Les première et seconde cavités peuvent être de même profondeur et de même largeur. Dans ce cas, la largeur du contact conducteur est strictement inférieure à deux fois la largeur des première et seconde cavités.

La présente invention concerne en outre une cellule photovoltaïque comprenant un substrat semi-conducteur, dopé selon un premier type de conductivité, dont la surface comprend un motif de structuration comportant au moins deux cavités et au moins un pilier, une zone dopée selon un second type de conductivité s'étendant à partir de la surface du substrat, l'au moins un pilier étant dopé selon le second type de conductivité. Une couche tampon est disposée au fond d'au moins une cavité. Un contact conducteur est disposé dans ladite au moins une cavité sur la couche tampon, le contact conducteur étant en contact avec le pilier.

Le pilier est entièrement dopé selon le second type de conductivité.

La largeur de l'au moins un pilier est inférieure ou égale à deux fois l'épaisseur de ladite zone dopée.

Selon un mode de réalisation de la présente invention, le motif de structuration comporte une cavité principale et une première et une seconde cavités secondaires disposées de part et d'autre de la cavité principale et séparées de celle-ci par un premier et un second piliers. La couche tampon est disposée au fond de la cavité principale. Le contact conducteur est disposé dans la cavité principale sur la couche tampon.

La profondeur de la première cavité secondaire et la profondeur de la seconde cavité secondaire sont inférieures ou égales à la profondeur de la cavité principale.

Les première et seconde cavités secondaires peuvent être de même profondeur et de même largeur.

Selon un mode de réalisation de la présente invention, le motif de structuration comporte une première cavité et une seconde cavité séparées par un pilier. La couche tampon est disposée au fond de la première cavité et au fond de la seconde cavité. Le contact conducteur est disposé dans les première et seconde cavités sur la couche tampon, autour du pilier.

Les première et seconde cavités peuvent être de même profondeur et de même largeur. Dans ce cas, la largeur du contact conducteur est strictement inférieure à deux fois la largeur des première et seconde cavités.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
Les figures 1A à 1D sont des vues en coupe illustrant de façon schématique des étapes successives d'un procédé de formation de contacts conducteurs d'une cellule photovoltaïque selon l'invention.
Les figures 2A à 2D sont des vues en coupe illustrant de façon schématique des étapes successives d'un autre procédé de formation de contacts conducteurs d'une cellule photovoltaïque selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

L'inventeur propose un procédé de formation de contacts conducteurs d'une cellule photovoltaïque permettant d'éloigner les contacts conducteurs de la jonction photovoltaïque. Plus précisément, l'inventeur propose d'éloigner de la jonction photovoltaïque l'interface entre le contact conducteur et la zone dopée à contacter.

Pour cela, l'inventeur propose de former une structuration particulière à la surface du substrat et d'utiliser une couche tampon localisée au fond des motifs de structuration.

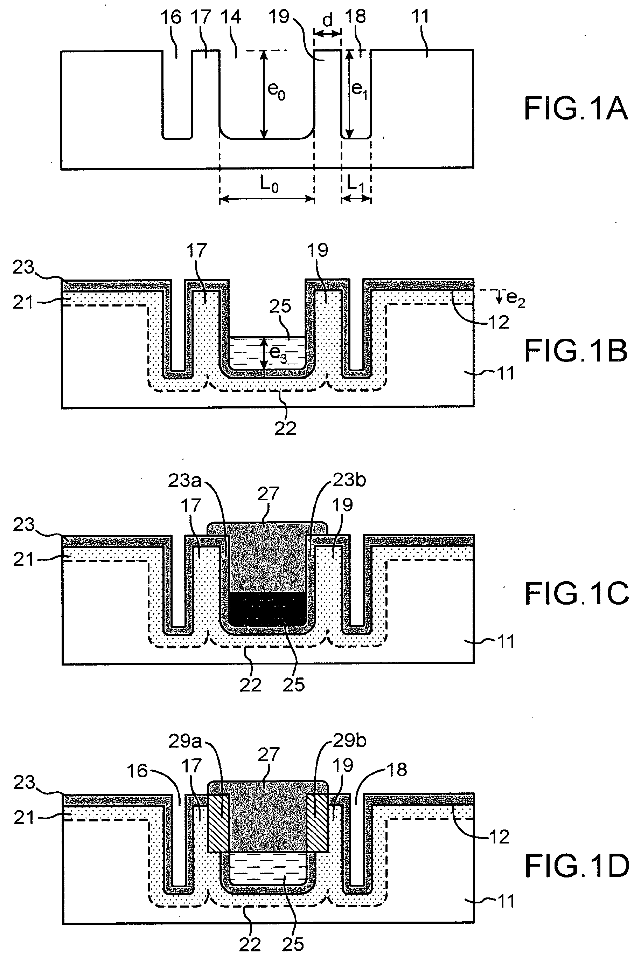

Les figures 1A à 1D sont des vues en coupe illustrant de façon schématique des étapes successives d'un procédé de formation de contacts conducteurs d'une cellule photovoltaïque.

La figure 1A représente un substrat en matériau semi-conducteur 11, par exemple en silicium, à la surface duquel un motif de structuration a été formé. Le motif de structuration comporte une cavité principale 14, de profondeur e₀ et de largeur L₀, et deux cavités secondaires 16 et 18 disposées de part et d'autre de la cavité principale 14. La cavité secondaire 16 est séparée de la cavité principale 14 par un pilier 17 en matériau semi-conducteur 11, de largeur d. La cavité secondaire 18 est séparée de la cavité principale 14 par un pilier 19 en matériau semi-conducteur 11, de largeur d. Les cavités 16 et 18 ont par exemple la même profondeur e₁ et la même largeur L₁. La profondeur des cavités secondaires 16 et 18 est inférieure ou égale à la profondeur e₀ de la cavité principale 14. De préférence, la largeur des cavités secondaires 16 et 18 est inférieure ou égale à la largeur L₀ de la cavité principale 14.

Les cavités 14, 16 et 18 sont avantageusement formées par gravure du substrat semi-conducteur 11, à partir de la surface du substrat. De préférence, les cavités sont formées par photolithographie puis gravure par voie exclusivement chimique (gravure humide) ou par voie laser associée à une gravure humide. De telles méthodes de gravure permettent de former le motif de structuration tout en générant peu de défauts.

La figure 1B illustre la formation d'une zone dopée 21, de type de conductivité opposé à celui du substrat 11, à partir de la surface structurée 12 du substrat 11 jusqu'à une profondeur e₂ dans le substrat. La zone dopée 21 est couramment appelée émetteur. La zone dopée 21 est formée par voie thermique, c'est-à-dire par insertion puis substitution d'éléments dopants dans le réseau cristallin du substrat semi-conducteur 11. Toute méthode de dopage permettant d'obtenir une zone dopée 21 conforme par rapport au motif de structuration de surface du substrat 11, c'est-à-dire d'épaisseur constante par rapport à la surface structurée 12 du substrat, pourra être utilisée. Par exemple, la zone dopée 21 peut être formée par diffusion thermique ou par implantation ionique ou par immersion plasma.

La jonction photovoltaïque 22 formée par le substrat 11 et la zone dopée 21 est située à une distance e₂ de la surface structurée 12 du substrat. L'homme du métier saura choisir l'épaisseur e₂ de la zone dopée 21 en fonction des caractéristiques de la cellule photovoltaïque à fabriquer.

La largeur d des piliers 17 et 19 est préalablement choisie de sorte que les piliers 17 et 19 soient entièrement dopés selon le type de conductivité opposé à celui du substrat 11, autrement dit de sorte que les piliers 17 et 19 soient formés uniquement de la zone dopée 21 et ne comprennent pas de jonction P/N. La largeur d des piliers 17 et 19 est choisie de sorte à être inférieure ou égale à deux fois l'épaisseur e₂ de la zone dopée 21.

Une couche 23, électriquement isolante, par exemple en nitrure de silicium, est formée sur la surface structurée 12 du substrat 11. Il s'agit avantageusement d'une couche antireflet et/ou d'une couche de passivation.

Une couche dite « tampon » 25 est formée au fond de la cavité principale 14, sur la couche 23. L'épaisseur e₃ de la couche tampon 25 est inférieure à la profondeur e₀ de la cavité principale 14. La couche tampon 25 est destinée à servir de barrière entre la pâte conductrice (et le contact conducteur formé ultérieurement) et la partie de la couche 23 la plus proche de la jonction photovoltaïque 22.

Pour former la couche tampon 25, on choisira un matériau non poreux, c'est-à-dire un matériau ne laissant pas passer les particules contenues dans la pâte conductrice utilisée ultérieurement pour former le contact conducteur. Le matériau choisi sera également inactif chimiquement par rapport à la pâte conductrice. Le matériau choisi pour la couche tampon 25 présente avantageusement une porosité ouverte inférieure ou égale à 1 µm et de préférence inférieure ou égale à 500 nm. La porosité ouverte peut être évaluée par microscopie électronique à balayage (MEB).

La couche tampon 25 peut être électriquement conductrice. Dans ce cas, la couche tampon 25 est par exemple une couche de nickel obtenue par pulvérisation, par exemple par dépôt physique en phase vapeur (PVD, « Physical Vapor Deposition »). Selon une alternative, la couche tampon 25 peut être électriquement isolante. Dans ce cas, la couche tampon 25 est par exemple en oxyde de silicium ou en verre obtenu par centrifugation connu sous le nom anglo-saxon de « spin on glass » ou en un matériau polymère par exemple déposé par sérigraphie.

La figure 1C illustre la formation d'un contact conducteur 27 par dépôt sérigraphique (ou sérigraphie) dans la cavité principale 14, sur la couche tampon 25. Le contact conducteur 27 recouvre des portions 23a, 23b de la couche 23 recouvrant les piliers 17 et 19. Une pâte conductrice à base d'argent et/ou d'aluminium est par exemple utilisée pour former le contact conducteur 27. L'ouverture de l'écran de sérigraphie utilisé est par exemple de largeur supérieure à la largeur L₀ de la cavité principale 14. Ainsi, même en cas de désalignement de l'écran de sérigraphie par rapport à la cavité 14, le contact conducteur 27 recouvre des portions de la couche 23 recouvrant les piliers 17 et 19.

La figure 1D illustre la structure obtenue après un traitement thermique de reprise de contact du contact conducteur 27 sur la zone dopée 21. Le traitement thermique est par exemple réalisé dans un four dit « à passage » utilisant des lampes infrarouge. Il permet d'activer des composants contenus dans la pâte conductrice utilisée pour former le contact conducteur 27, par exemple de la fritte de verre. Sous l'effet du traitement thermique, la fritte de verre grave les portions 23a et 23b de la couche 23 qui sont en contact avec le contact conducteur 27. La couche 23 est éliminée entre le contact conducteur 27 et une partie de la zone dopée 21 située dans les piliers 17 et 19. L'avancée du contact conducteur 27 dans la zone dopée 21 s'effectue sensiblement perpendiculairement à l'interface entre le contact conducteur 27 et la zone dopée 21. Cette avancée du contact 27 dans la zone dopée 21 est représentée par des zones hachurées 29a et 29b.

On a ainsi formé un contact conducteur sur la zone dopée 21, les zones 29a et 29b d'interface entre le contact conducteur 27 et la zone dopée 21 étant disposées à distance de la jonction photovoltaïque 22.

Un avantage d'un procédé du type de celui décrit en relation avec les figures 1A-1D réside dans le fait qu'il permet d'éviter tout risque de court-circuit et/ou de dégradation électrique de la jonction photovoltaïque. Il en résulte une amélioration des performances des cellules photovoltaïques.

A titre d'exemple de dimensions :
- la largeur L₀ de la cavité principale 14 est inférieure ou égale à 200 µm, et avantageusement comprise entre 20 µm et 90 µm ;
- la largeur L₁ des cavités secondaires 16 et 18 est inférieure ou égale à 50 µm, et avantageusement comprise entre 0,5 µm et 10 µm ;
- la profondeur e₀ de la cavité principale 14 est inférieure ou égale à 40 µm, et avantageusement comprise entre 20 µm et 30 µm ;
- la profondeur e₁ des cavités secondaires 16 et 18 est inférieure ou égale à eo, et avantageusement telle que [e₀-e₃] < e₁ ≤ eo;
- l'épaisseur e₃ de la couche tampon 25 est inférieure ou égale à 10 µm, et avantageusement comprise entre 1 µm et 5 µm ; et
- l'épaisseur e₂ de la zone dopée 21 est supérieure ou égale à 0,5 µm et inférieure ou égale à 2 µm.

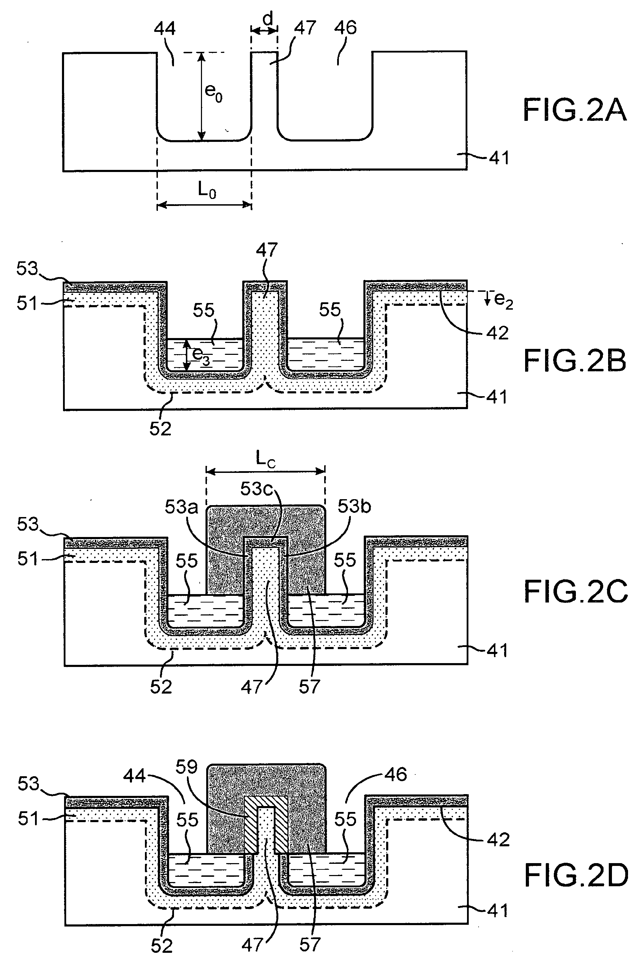

Les figures 2A à 2D sont des vues en coupe illustrant de façon schématique des étapes successives d'un autre mode de réalisation d'un procédé de formation de contacts conducteurs d'une cellule photovoltaïque.

La figure 2A représente un substrat en matériau semi-conducteur 41, par exemple en silicium, à la surface duquel un motif de structuration a été formé. Le motif de structuration comporte deux cavités 44 et 46 séparées par un pilier 47 en matériau semi-conducteur 41, de largeur d. Les cavités 44 et 46 ont par exemple la même profondeur e₀ et la même largeur L₀.

Les cavités 44 et 46 sont avantageusement formées par gravure du substrat semi-conducteur 41, à partir de la surface du substrat. Comme dans le mode de réalisation illustré en figures 1A-1D, les cavités sont de préférence formées par photolithographie puis gravure par voie exclusivement chimique ou par voie laser associée à une gravure humide.

La figure 2B illustre la formation d'une zone dopée 51, de type de conductivité opposé à celui du substrat 41, à partir de la surface structurée 42 du substrat 41 jusqu'à une profondeur e₂ dans le substrat. Comme dans le mode de réalisation illustré en figures 1A-1D, la zone dopée 51 est formée par voie thermique. Toute méthode de dopage permettant d'obtenir une zone dopée 51 conforme par rapport au motif de structuration de surface du substrat 41 pourra être utilisée. Par exemple, la zone dopée 51 peut être formée par diffusion thermique ou par implantation ionique ou par immersion plasma. La jonction photovoltaïque 52 formée par le substrat 41 et la zone dopée 51 est située à une distance e₂ de la surface structurée 42 du substrat.

La largeur d du pilier 47 est préalablement choisie de sorte que le pilier 47 soit entièrement dopé selon le type de conductivité opposé à celui du substrat 41, autrement dit de sorte que le pilier 47 soit formé uniquement de la zone dopée 51 et ne comprenne pas de jonction P/N. La largeur d du pilier 47 est choisie de sorte à être inférieure ou égale à deux fois l'épaisseur e₂ de la zone dopée 51.

Une couche 53, électriquement isolante, est formée sur la surface structurée 42 du substrat 41. Il s'agit avantageusement d'une couche antireflet et/ou d'une couche de passivation.

Une couche tampon 55 est formée au fond de chaque cavité 44 et 46. L'épaisseur e₃ de la couche tampon 55 est inférieure à la profondeur e₀ des cavités 44 et 46. La couche tampon 55 est destinée à servir de barrière entre la pâte conductrice (et le contact conducteur formé ultérieurement) et les parties de la couche 53 les plus proches de la jonction photovoltaïque 52. Comme dans le mode de réalisation précédent, la couche tampon 55 est formée en un matériau non poreux et inactif chimiquement par rapport à la pâte conductrice utilisée ultérieurement pour former le contact conducteur. Le matériau choisi pour la couche tampon 55 présente avantageusement une porosité ouverte inférieure ou égale à 1 µm et de préférence inférieure ou égale à 500 nm. La couche tampon 55 peut être électriquement conductrice ou électriquement isolante.

La figure 2C illustre la formation d'un contact conducteur 57 par dépôt sérigraphique (ou sérigraphie) dans les cavités 44 et 46, sur la couche tampon 55 et autour du pilier 47. Une pâte métallique à base d'argent et/ou d'aluminium est par exemple utilisée pour former le contact conducteur 57. La largeur L_{c} du contact 57 est choisie de façon qu'il ne remplisse pas entièrement les cavités 44 et 46, autrement dit de façon que le contact 57 recouvre seulement des portions 53a, 53b et 53c de la couche 53 recouvrant le pilier 47. Le contact 57 ne recouvre pas les portions de la couche 53 les plus proches de la jonction photovoltaïque 52. La largeur L_{c} du contact 57 est choisie de façon à être strictement inférieure à la somme des largeurs des cavités 44 et 46. Dans le cas où les cavités 44 et 46 ont la même largeur Lo, la largeur L_{c} du contact 57 est choisie de façon à être strictement inférieure à deux fois la largeur L₀.

La figure 2D illustre la structure obtenue après un traitement thermique de reprise de contact du contact conducteur 57 sur la zone dopée 51. Sous l'effet du traitement thermique, les portions 53a, 53b et 53c de la couche 53 qui sont en contact avec le contact conducteur 57 sont gravées. La couche 53 est éliminée entre le contact conducteur 57 et une partie de la zone dopée 51 située dans le pilier 47. L'avancée du contact conducteur 57 dans la zone dopée 51 s'effectue sensiblement perpendiculairement à l'interface entre le contact conducteur 57 et la zone dopée 51. Cette avancée du contact 57 dans la zone dopée 51 est représentée par une zone hachurée 59.

On a ainsi formé un contact conducteur sur la zone dopée 51, la zone 59 d'interface entre le contact conducteur 57 et la zone dopée 51 étant disposée à distance de la jonction photovoltaïque 52.

Un avantage d'un procédé du type de celui décrit en relation avec les figures 2A-2D réside dans le fait qu'il permet d'éviter tout risque de court-circuit et/ou de dégradation électrique de la jonction photovoltaïque. Il en résulte une amélioration des performances des cellules photovoltaïques.

A titre d'exemple de dimensions :
- la largeur L₀ des cavités 44 et 46 est inférieure ou égale à 200 µm, et avantageusement comprise entre 20 µm et 90 µm ;
- la profondeur e₀ des cavités 44 et 46 est inférieure ou égale à 40 µm, et avantageusement comprise entre 20 µm et 30 µm ;
- l'épaisseur e₃ de la couche tampon 55 est inférieure ou égale à 10 µm, et avantageusement comprise entre 1 µm et 5 µm ; et
- l'épaisseur e₂ de la zone dopée 51 est supérieure ou égale à 0,5 µm et inférieure ou égale à 2 µm.

La figure 1D représente un mode de réalisation d'une cellule photovoltaïque.

La cellule photovoltaïque comprend un substrat semi-conducteur 11, dont la surface comprend un motif de structuration du côté de la face 12 de la cellule destinée à être exposée au rayonnement lumineux. Le motif de structuration comporte une cavité principale 14 et deux cavités secondaires 16 et 18 disposées de part et d'autre de la cavité principale 14 et séparées de celle-ci par des piliers 17 et 19 en matériau semi-conducteur 11. Les cavités 16 et 18 ont par exemple la même profondeur e₁ et la même largeur L₁. La profondeur des cavités secondaires 16 et 18 est inférieure ou égale à la profondeur e₀ de la cavité principale 14.

Une zone dopée 21, de type de conductivité opposé à celui du substrat 11, s'étend à partir de la surface structurée 12 du substrat 11 jusqu'à une profondeur e₂ dans le substrat. La zone dopée 21 est conforme par rapport à la surface structurée 12 du substrat 11. La zone dopée 21 est continue, y compris dans les piliers 17 et 19. Les piliers 17 et 19 sont entièrement dopés selon le type de conductivité opposé à celui du substrat 11, autrement dit les piliers 17 et 19 sont formés uniquement de la zone dopée 21 et ne comprennent pas de jonction P/N. La largeur d des piliers 17 et 19 est inférieure ou égale à deux fois l'épaisseur e₂ de la zone dopée 21.

Une couche 23 électriquement isolante, par exemple une couche antireflet et/ou une couche de passivation, recouvre la surface structurée 12 du substrat 11, excepté des portions supérieures des piliers 17 et 19. La couche 23 est conforme par rapport à la surface structurée 12 du substrat 11.

Une couche tampon 25 est disposée au fond de la cavité principale 14, sur la couche 23. Un contact conducteur 27 est disposé dans la cavité principale 14, sur la couche tampon 25. Le contact conducteur 27 est en contact direct avec les portions des piliers 17 et 19 non recouvertes de la couche 23, situées au-dessus de la couche tampon 25.

Les zones 29a et 29b d'interface entre le contact conducteur 27 et la zone dopée 21 sont disposées à distance de la jonction photovoltaïque 22 formée par le substrat 11 et la zone dopée 21.

La figure 2D représente un autre mode de réalisation d'une cellule photovoltaïque.

La cellule photovoltaïque comprend un substrat semi-conducteur 41 dont la surface comprend un motif de structuration du côté de la face 42 de la cellule destinée à être exposée au rayonnement lumineux. Le motif de structuration comporte deux cavités 44 et 46 séparées par un pilier 47 en matériau semi-conducteur 41. Les cavités 44 et 46 ont par exemple la même profondeur e₀ et la même largeur L₀.

Une zone dopée 51, de type de conductivité opposé à celui du substrat 41, s'étend à partir de la surface structurée 42 du substrat 41 jusqu'à une profondeur e₂ dans le substrat. La zone dopée 51 est conforme par rapport à la surface structurée 42 du substrat 41. La zone dopée 51 est continue, y compris dans le pilier 47. Le pilier 47 est entièrement dopé selon le type de conductivité opposé à celui du substrat 41, autrement dit le pilier 47 est formé uniquement de la zone dopée 51 et ne comprend pas de jonction P/N. La largeur d du pilier 47 est inférieure ou égale à deux fois l'épaisseur e₂ de la zone dopée 51.

Une couche 53 électriquement isolante, par exemple une couche antireflet et/ou une couche de passivation, recouvre la surface structurée 42 du substrat 41, excepté une portion supérieure du pilier 47. La couche 53 est conforme par rapport à la surface structurée 42 du substrat 41.

Une couche tampon 55 est disposée au fond de chaque cavité 44 et 46, sur la couche 53. Un contact conducteur 57 est disposé dans les cavités 44 et 46, sur la couche tampon 55, autour du pilier 47. Le contact conducteur 57 est en contact direct avec la portion du pilier 47 située au-dessus de la couche tampon 55 et non recouverte de la couche 53. La largeur L_{c} du contact 57 est strictement inférieure à la somme des largeurs des cavités 44 et 46 (L_{c} < 2 L₀ dans le cas où les cavités 44 et 46 ont la même largeur L₀), de sorte que le contact conducteur 57 ne recouvre pas les portions de la couche 53 les plus proches de la jonction photovoltaïque 52.

La zone 59 d'interface entre le contact conducteur 57 et la zone dopée 51 est disposée à distance de la jonction photovoltaïque 52 formée par le substrat 41 et la zone dopée 51.

## Revendications

1. Procédé de formation d'une cellule photovoltaïque, comprenant les étapes suivantes :
a) former un motif de structuration, comportant au moins deux cavités et au moins un pilier, à partir de la surface d'un substrat semi-conducteur (11, 41) ;
b) former à partir de la surface du substrat une zone dopée (21, 51) selon le type de conductivité opposé à celui du substrat, de façon que le pilier soit entièrement formé de ladite zone dopée ;
c) former une couche tampon (25, 55) au fond d'au moins une cavité ; et
d) former un contact conducteur (27, 57) avec la zone dopée située dans le pilier, par dépôt sérigraphique dans ladite au moins une cavité sur la couche tampon et traitement thermique de reprise de contact.

2. Procédé selon la revendication 1, dans lequel, lors de l'étape b), la zone dopée (21, 51) est formée de façon conforme par rapport au motif de structuration.

3. Procédé selon la revendication 1 ou 2, comprenant en outre, entre les étapes b) et c), une étape de formation d'une couche électriquement isolante (23, 53) sur la surface du substrat, ladite couche électriquement isolante étant par exemple une couche antireflet et/ou une couche de passivation.

4. Procédé selon l'une des revendications 1 à 3, dans lequel la largeur (d) de l'au moins un pilier est inférieure ou égale à deux fois l'épaisseur (e₂) de ladite zone dopée (21, 51).

5. Procédé selon l'une des revendications 1 à 4, dans lequel :
- lors de l'étape a), on forme un motif de structuration comportant une cavité principale (14) et une première (16) et une seconde (18) cavités secondaires disposées de part et d'autre de la cavité principale et séparées de celle-ci par un premier (17) et un second (19) piliers ;
- lors de l'étape c), on forme une couche tampon (25) au fond de la cavité principale (14) ; et
- lors de l'étape d), on forme un contact conducteur (27) dans la cavité principale (14).

6. Procédé selon la revendication 5, dans lequel la profondeur de la première cavité secondaire (16) et la profondeur de la seconde cavité secondaire (18) sont inférieures ou égales à la profondeur (e₀) de la cavité principale (14).

7. Procédé selon la revendication 5 ou 6, dans lequel les première et seconde cavités secondaires (16, 18) ont la même profondeur (e₁) et la même largeur (L₁).

8. Procédé selon l'une des revendications 1 à 4, dans lequel :
- lors de l'étape a), on forme un motif de structuration comportant une première cavité (44) et une seconde cavité (46) séparées par un pilier (47) ;
- lors de l'étape c), on forme une couche tampon (55) au fond des première et seconde cavités (44, 46) ; et
- lors de l'étape d), on forme un contact conducteur (57) dans les première et seconde cavités (44, 46) autour du pilier (47).

9. Procédé selon la revendication 8, dans lequel les première et seconde cavités (44, 46) ont la même profondeur (e₀) et la même largeur (L₀).

10. Procédé selon la revendication 9, dans lequel la largeur (L_{c}) du contact conducteur (57) est strictement inférieure à deux fois la largeur (L₀) des première et seconde cavités (44, 46).

11. Cellule photovoltaïque comprenant :
- un substrat semi-conducteur (11, 41), dopé selon un premier type de conductivité, dont la surface comprend un motif de structuration comportant au moins deux cavités et au moins un pilier, une zone dopée (21, 51) selon un second type de conductivité s'étendant à partir de la surface (12, 42) du substrat, l'au moins un pilier étant entièrement dopé selon le second type de conductivité ;
- une couche tampon (25, 55) disposée au fond d'au moins une cavité ; et
- un contact conducteur (27, 57) disposé dans ladite au moins une cavité sur la couche tampon, le contact conducteur étant en contact avec le pilier.

12. Cellule photovoltaïque selon la revendication 11, dans laquelle la largeur (d) de l'au moins un pilier est inférieure ou égale à deux fois l'épaisseur (e₂) de ladite zone dopée (21, 51).

13. Cellule photovoltaïque selon la revendication 11 ou 12, dans laquelle :
- le motif de structuration comporte une cavité principale (14) et une première (16) et une seconde (18) cavités secondaires disposées de part et d'autre de la cavité principale et séparées de celle-ci par un premier (17) et un second (19) piliers ;
- la couche tampon (25) est disposée au fond de la cavité principale (14) ;
et le contact conducteur (27) est disposé dans la cavité principale (14) sur la couche tampon.

14. Cellule photovoltaïque selon la revendication 13, dans laquelle la profondeur de la première cavité secondaire (16) et la profondeur de la seconde cavité secondaire (18) sont inférieures ou égales à la profondeur (e₀) de la cavité principale (14).

15. Cellule photovoltaïque selon la revendication 13 ou 14, dans laquelle les première et seconde cavités secondaires (16, 18) ont la même profondeur (e₁) et la même largeur (L₁).

16. Cellule photovoltaïque selon la revendication 11 ou 12, dans laquelle :
- le motif de structuration comporte une première cavité (44) et une seconde cavité (46) séparées par un pilier (47) ;
- la couche tampon (55) est disposée au fond de la première cavité (44) et au fond de la seconde cavité (46) ;
et le contact conducteur (57) est disposé dans les première et seconde cavités (44, 46) sur la couche tampon, autour du pilier (47).

17. Cellule photovoltaïque selon la revendication 16, dans laquelle les première et seconde cavités (44, 46) ont la même profondeur (e₀) et la même largeur (L₀).

18. Cellule photovoltaïque selon la revendication 17, dans laquelle la largeur (L_{c}) du contact conducteur (57) est strictement inférieure à deux fois la largeur (L₀) des première et seconde cavités (44, 46).

## Patentansprüche

1. Verfahren zum Bilden einer Fotovoltaikzelle, umfassend die folgenden Schritte:
a) Bilden eines Strukturierungsmusters, umfassend wenigstens zwei Hohlräume und wenigstens eine Säule, ausgehend von der Oberfläche eines Halbleitersubstrats (11, 41);
b) ausgehend von der Oberfläche des Substrats, Bilden einer dotierten Zone (21, 51) vom entgegengesetzten Leitfähigkeitstyp wie das Substrat, so dass die Säule vollständig aus der dotierten Zone gebildet ist;
c) Bilden einer Pufferschicht (25, 55) am Grund von wenigstens einem Hohlraum; und
d) Bilden eines leitfähigen Kontakts (27, 57) mit der an der Säule positionierten dotierten Zone durch Siebablagerung in dem wenigstens einen Hohlraum auf der Pufferschicht und thermische Behandlung zur Kontakt-Wiederherstellung.

2. Verfahren nach Anspruch 1, wobei während Schritt b) die dotierte Zone (21, 51) gleichförmig bezüglich dem Strukturierungsmuster gebildet wird.

3. Verfahren nach Anspruch 1 oder 2, ferner umfassend, zwischen den Schritten b) und c), einen Schritt eines Bildens einer elektrisch isolierenden Schicht (23, 53) auf der Oberfläche des Substrats, wobei die elektrisch isolierende Schicht beispielsweise eine Antireflexschicht und/oder eine Passivierungsschicht ist.

4. Verfahren nach einem der Ansprüche 1 bis 3, wobei die Dicke (d) der wenigstens einen Säule kleiner oder gleich zwei Mal der Dicke (e₂) der dotierten Zone (21, 51) ist.

5. Verfahren nach einem der Ansprüche 1 bis 4, wobei:
- während des Schritts a) ein Strukturierungsmuster gebildet wird, welches einen Haupthohlraum (14) und einen ersten (16) und einen zweiten (18) Sekundärhohlraum umfasst, welche beiderseits des Haupthohlraums angeordnet und voneinander durch eine erste (17) und eine zweite (19) Säule getrennt sind;
- während des Schritts c) eine Pufferschicht (25) am Grund des Haupthohlraums (14) gebildet wird; und
- während des Schritts d) ein leitfähiger Kontakt (27) in dem Haupthohlraum (14) gebildet wird.

6. Verfahren nach Anspruch 5, wobei die Tiefe des ersten Sekundärhohlraums (16) und die Tiefe des zweiten Sekundärhohlraums (18) kleiner oder gleich der Tiefe (e₀) des Haupthohlraums (14) sind.

7. Verfahren nach Anspruch 5 oder 6, wobei der erste und zweite Sekundärhohlraum (16, 18) die gleiche Tiefe (e₁) und die gleiche Breite (L₁) aufweisen.

8. Verfahren nach einem der Ansprüche 1 bis 4, wobei:
- während des Schritts a) ein Strukturierungsmuster gebildet wird, welches einen ersten Hohlraum (44) und einen zweiten Hohlraum (46) umfasst, welche durch eine Säule (47) getrennt sind;
- während Schritt c) eine Pufferschicht (55) am Grund des ersten und zweiten Hohlraums (44, 46) gebildet wird; und
- während des Schritts d) ein leitfähiger Kontakt (57) in dem ersten und zweiten Hohlraum (44, 46) um die Säule (47) herum gebildet wird.

9. Verfahren nach Anspruch 8, wobei der erste und zweite Hohlraum (44, 46) die gleiche Tiefe (e₀) und die gleiche Breite (L₀) aufweisen.

10. Verfahren nach Anspruch 9, wobei die Dicke (L_{c}) des leitfähigen Kontakts (57) streng kleiner als zwei Mal die Dicke (L₀) des ersten und zweiten Hohlraums (44, 46) ist.

11. Fotovoltaikzelle, umfassend:
- ein Halbleitersubstrat (11, 41), welches gemäß einem ersten Leitfähigkeitstyp dotiert ist, dessen Oberfläche ein Strukturierungsmuster umfasst, welches wenigstens zwei Hohlräume und wenigstens eine Säule umfasst, wobei sich eine dotierte Zone (21, 51) gemäß einem zweiten Leitfähigkeitstyp ausgehend von der Oberfläche (12, 41) des Substrats erstreckt, wobei die wenigstens eine Säule vollständig gemäß dem zweiten Leitfähigkeitstyp dotiert ist;
- eine Pufferschicht (25, 55), welche am Grund des wenigstens einen Hohlraums angeordnet ist; und
- einen leitfähigen Kontakt (27, 57), welcher in dem wenigstens einen Hohlraum auf der Pufferschicht angeordnet ist, wobei der leitfähige Kontakt mit der Säule in Kontakt ist.

12. Fotovoltaikzelle nach Anspruch 11, wobei die Dicke (d) der wenigstens einen Säule kleiner oder gleich zwei Mal der Dicke (e₂) der dotierten Zone (21, 51) ist.

13. Fotovoltaikzelle nach Anspruch 11 oder 12, wobei:
- das Strukturierungsmuster einen Haupthohlraum (14) und einen ersten (16) und einen zweiten (18) Sekundärhohlraum umfasst, welche beiderseits des Haupthohlraums angeordnet und voneinander durch eine erste (17) und eine zweite (19) Säule getrennt sind;
- die Pufferschicht (25) am Grund des Haupthohlraums (14) angeordnet ist;
und der leitfähige Kontakt (27) in dem Haupthohlraum (14) auf der Pufferschicht angeordnet ist.

14. Fotovoltaikzelle nach Anspruch 13, wobei die Tiefe des ersten Sekundärhohlraums (16) und die Tiefe des zweiten Sekundärhohlraums (18) kleiner oder gleich der Tiefe (e₀) des Haupthohlraums (14) sind.

15. Fotovoltaikzelle nach Anspruch 13 oder 14, wobei der erste und zweite Sekundärhohlraum (16, 18) die gleiche Tiefe (e₁) und die gleiche Breite (L₁) aufweisen.

16. Fotovoltaikzelle nach Anspruch 11 oder 12, wobei:
- das Strukturierungsmuster einen ersten Hohlraum (44) und einen zweiten Hohlraum (46) umfasst, welche durch eine Säule (47) getrennt sind;
- die Pufferschicht (55) am Grund des ersten Hohlraums (44) und am Grund des zweiten Hohlraums (46) gebildet ist;
und der leitfähige Kontakt (57) in dem ersten und zweiten Hohlraum (44, 46) auf der Pufferschicht um die Säule (47) herum angeordnet ist.

17. Fotovoltaikzelle nach Anspruch 16, wobei der erste und zweite Hohlraum (44, 46) die gleiche Tiefe (e₀) und die gleiche Breite (L₀) aufweisen.

18. Fotovoltaikzelle nach Anspruch 17, wobei die Dicke (L_{c}) des leitfähigen Kontakts (57) streng kleiner als zwei Mal die Dicke (L₀) des ersten und zweiten Hohlraums (44, 46) ist.

## Claims

1. A method for forming a photovoltaic cell comprising the following steps:
a) forming a structuration pattern, including at least two cavities and at least one pillar, from the surface of a semiconductor substrate (11, 41);
b) forming from the surface of the substrate a doped area (21, 51) according to the type of conductivity opposite to that of the substrate, so that the pillar is entirely formed with said doped area;
c) forming a buffer layer (25, 55) at the bottom of at least one cavity;
d) forming a conductive contact (27, 57) with the doped area located in the pillar, by screen-printing deposition into said at least one cavity on the buffer layer and heat treatment for resuming contact.

2. The method according to claim 1, wherein, during step b), the doped area (21, 51) is formed in a compliant way with respect to the structuration pattern.

3. The method according to claim 1 or 2, further comprising, between steps b) and c), a step for forming an electrically insulating layer (23, 53) on the surface of the substrate, said electrically insulating layer for example being an antireflection layer and/or a passivation layer.

4. The method according to one of claims 1 to 3, wherein the width (d) of said at least one pillar is less than or equal to twice the thickness (e₂) of said doped area (21, 51).

5. The method according to one of claims 1 to 4, wherein:
- during step a), a structuration pattern is formed including a main cavity (14) and first (16) and second (18) secondary cavities positioned on either side of the main cavity and separated from the latter by first (17) and second (19) pillars;
- during step c), a buffer layer (25) is formed at the bottom of the main cavity (14); and
- during step d), a conductive contact (27) is formed in the main cavity (14).

6. The method according to claim 5, wherein the depth of the first secondary cavity (16) and the depth of the second secondary cavity (18) are less than or equal to the depth (e₀) of the main cavity (14).

7. The method according to claim 5 or 6, wherein the first and second secondary cavities (16, 18) have the same depth (e₁) and the same width (L₁).

8. The method according to one of claims 1 to 4, wherein:
- during step a), a structuration pattern is formed including a first cavity (44) and a second cavity (46) separated by a pillar (47);
- during step c), a buffer layer (55) is formed at the bottom of the first and second cavities (44, 46); and
- during step d), a conductive contact (57) is formed in the first and second cavities (44, 46) around the pillar (47).

9. The method according to claim 8, wherein the first and second cavities (44, 46) have the same depth (e₀) and the same width (L₀).

10. The method according to claim 9, wherein the width (L_{c}) of the conductive contact (57) is strictly less than twice the width (L₀) of the first and second cavities (44, 46).

11. A photovoltaic cell comprising:
- a semiconductor substrate (11, 41) doped according to a first type of conductivity, the surface of which comprises a structuration pattern including at least two cavities and at least one pillar, a doped area (21, 51) according to a second type of conductivity extending from the surface (12, 42) of the substrate, said at least one pillar being entirely doped according to the second type of conductivity;
- a buffer layer (25, 55) positioned at the bottom of a least one cavity; and
- a conductive contact (27, 57) positioned in said at least one cavity on the buffer layer, the conductive contact being in contact with the pillar.

12. The photovoltaic cell according to claim 11, wherein the width (d) of said at least one pillar is less than or equal to twice the thickness (e₂) of said doped area (21, 51).

13. The photovoltaic cell according to claim 11 or 12, wherein:
- the structuration pattern includes a main cavity (14) and first (16) and second (18) secondary cavities positioned on either side of the main cavity and separated therefrom by first (17) and second (19) pillars;
- the buffer layer (25) is positioned at the bottom of the main cavity (14);
and the conductive contact (27) is positioned in the main cavity (14) on the buffer layer.

14. The photovoltaic cell according to claim 13, wherein the depth of the first secondary cavity (16) and the depth of the second secondary cavity (18) are less than or equal to the depth (e₀) of the main cavity (14).

15. The photovoltaic cell according to claim 13 or 14, wherein the first and second secondary cavities (16, 18) have the same depth (e₁) and the same width (L₁).

16. The photovoltaic cell according to claim 11 or 12, wherein:
- the structuration pattern includes a first cavity (44) and a second cavity (46) separated by a pillar (47);
- the buffer layer (55) is positioned at the bottom of the first cavity (44) and at the bottom of the second cavity (46);
And the conductive contact (57) is positioned in the first and second cavities (44, 46) on the buffer layer, around the pillar (47).

17. The photovoltaic cell according to claim 16, wherein
the first and second cavities (44, 46) have the same depth (e₀) and the same width (L₀).

18. The photovoltaic cell according to claim 17, wherein the width (L_{c}) of the conductive contact (57) is strictly less than twice the width (L₀) of the first and second cavities (44, 46).
